(19) Europäisches Patentamt
European Patent Office
Office européen des brevets

(11) EP 1 048 709 A1

(12) # EUROPEAN PATENT APPLICATION
published in accordance with Art. 158(3) EPC

(43) Date of publication:
**02.11.2000 Bulletin 2000/44**

(21) Application number: **99949415.6**

(22) Date of filing: **26.10.1999**

(51) Int. Cl.[7]: **C09J 163/00**, C09J 109/02, C09J 161/10, H05K 1/03

(86) International application number:
**PCT/JP99/05896**

(87) International publication number:
**WO 00/26318 (11.05.2000 Gazette 2000/19)**

(84) Designated Contracting States:
**DE FR GB**

(30) Priority: **30.10.1998 JP 30928098**

(71) Applicant:
**Mitsui Chemicals, Inc.**
**Tokyo 100-6070 (JP)**

(72) Inventors:
- **YAMASAKI, Susumu**
  **Mitsui Chemicals Inc.**
  **Ichihara-shi, Chiba 299-0108 (JP)**
- **SUETSUGU, Toshio**
  **Mitsui Chemicals Inc.**
  **Ichihara-shi, Chiba 299-0108 (JP)**
- **SOEJIMA, Wataru**
  **Mitsui Chemicals Inc.**
  **Ichihara-shi, Chiba 299-0108 (JP)**
- **ISHIGURO, Masaharu**
  **Mitsui Chemicals Inc.**
  **Chiyoda-ku, Tokyo 100-6070 (JP)**

(74) Representative:
**Cresswell, Thomas Anthony**
**J.A. KEMP & CO.**
**14 South Square**
**Gray's Inn**
**London WC1R 5LX (GB)**

(54) **ADHESIVE COMPOSITION**

(57) An adhesive composition comprising (1) a phosphoric acid ester specified by general formula (I), (2) a phenolic hydroxyl-containing aromatic compound having a softening point of 60 to 200°C, (3) an epoxy resin and (4) a carboxyl-containing nitrile-butadine rubber, a ratio of the components (2), (3) and (4) being 0 < the component (2)/(the component (3) + the component (4)) < 1 . The composition is suitable for use in a printed circuit board, especially for a flexible printed circuit board.

The invention also provides a flexible printed circuit board prepared by using the adhesive composition.

EP 1 048 709 A1

## Description

### TECHNICAL FIELD

The present invention relates to an adhesive composition. More particularly, the invention relates to an adhesive composition having excellent flame retardancy, adhesion strength, soldering heat resistance, thermal aging resistance and tack-free properties and is thus suitable for use in a printed circuit board, especially in a flexible printed circuit board.

### TECHNICAL BACKGROUND

Printed circuits have been used in various fields such as cameras, electronic calculators, telephones (home use and PHS), printers and audio equipment including DVD. For printed circuits, there is used a printed circuit board prepared by adhering a metal foil such as a copper or aluminum foil to a thin board for printed circuit. In recent years, electric and electronic parts are increasingly becoming smaller in size, lighter in weight and more complicated in circuit design. For these reasons, a flexible printed circuit have come to be used more increasingly. In a flexible printed circuit board, a polyimide film, a polyester film and the like are generally used. Meanwhile, an adhesive between a thin circuit board and a metal foil plays an important role in such a printed circuit board. Particularly in a flexible printed circuit, it is significant to choose a proper adhesive. Various attempts have been made on adhesives to improve their properties but still there is a need for adhesives of more improved properties.

Adhesives for use in printed circuits, especially in flexible printed circuits are required not only to provide excellent adhesive properties but also to give more improved soldering heat resistance and thermal aging resistance. Moreover, requirements for flame retardancy of materials and combustion safety have become severe according to the environmental adaptability loudly claimed in these years.

Conventional fluorine, polyester, acrylic and urethane resin type adhesives, which are known to be adhesives for flexible printed circuit boards, do not fully meet the requirements for the properties, inter alia, in soldering heat resistance and thermal aging resistance.

Turning to adhesives, it has been attempted to improve their properties. For example, Japanese Laid-Open Patent Application No. 61-76579 and others proposed a brominated epoxy resin/antimony trioxide type flame-retardant adhesive composition having allegedly excellent adhesion strength, soldering resistance and thermal aging resistance. For the brominated epoxy resin adhesives, it has been demanded to be bromine-free, since European and many other countries have been paying keen attention to environmental problems in recent years, as represented by the Dioxin Regulation Bill approved by the German Federal Council in 1994. With respect to the antimony trioxide type adhesives, there is also a demand to remove antimony from these adhesives because antimony trioxide is of poisonous nature and thus requires careful handling. The brominated epoxy resin type flame-retardant adhesive changes its color by the liberated bromine when exposed to high temperatures over a long period of time so that thermal aging resistance is lowered. Furthermore, when a brominated epoxy resin type flame-retardant adhesive is used, the content of bromine in the adhesive is required to be more than the minimum necessary content for ensuring the flame retardant effect by bromine. It results in a large amount of the brominated epoxy resin and causes a limitation to the formulation of components.

As a result of extensive studies to develop adhesives with excellent properties that do not contain either bromine or antimony, the inventors have accomplished the present invention.

### DISCLOSURE OF THE INVENTION

The present invention provides a bromine- or antimony-free adhesive composition which shows excellent flame retardancy, adhesive strength, soldering heat resistance, thermal aging resistance and tack-free property, and thus suitable for use in a printed circuit board.

The present invention also provides a bromine- or antimony-free adhesive composition which shows excellent flame retardancy, adhesive strength, soldering heat resistance, thermal aging resistance and tack-free property, and thus suitable for use in a flexible printed circuit board.

In order to solve the foregoing problems, the inventors have made efforts to improve epoxy resin type flame-retardant adhesives based on phosphor compounds since they can be formulated more freely than brominated epoxy resins, do not liberate any bromine and thus, when exposed to high temperatures, will undergo minimized color change.

As a result of extensive investigations on phosphor-based compounds, it has been found that phosphoric acid esters can impart excellent flame retardancy. However, when these esters are applied to flexible printed circuit boards, it has been found that where the esters are used alone, large quantities of the esters are required to achieve desired flame retardancy and thus cause tackiness. Tackiness is a problem as dusts or the like are adsorbed onto the

exposed surface of the formed circuit board to occasionally cause failure of insulation in the circuit. Decreased soldering heat resistance is also an additional problem.

As a result of further investigations, the inventors have discovered that the co-presence of a phenolic hydroxyl-containing aromatic compound with the phosphoric acid ester could markedly improve flame retardancy. The use of the phenolic hydroxyl-containing aromatic compound could greatly reduce the quantity of the phosphoric acid ester while maintaining its flame retardancy so that the problems involved in phosphoric acid esters could be decreased considerably. It has also been found that the phenolic hydroxyl-containing aromatic compound is suited for providing a flexible printed circuit board because of good compatibility with the carboxyl-containing nitrile-butadine rubber and good flexibility. The present invention has thus been accomplished.

That is, the present invention provides an adhesive composition comprising (1) a phosphoric acid ester, (2) a phenolic hydroxyl-containing aromatic compound having a softening point of 60 to 200°C, (3) an epoxy resin and (4) a carboxyl-containing nitrile-butadine rubber.

As preferred phosphoric acid esters, there can be cited compounds represented by the following general formula (I):

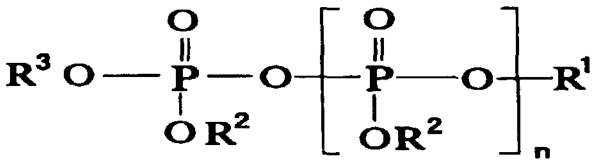

(I)

wherein n is an integer of not smaller than 0, preferably an integer of 0 to 2; each of $R^1$, $R^2$ and $R^3$ independently represents hydrogen or an alkyl group or an aromatic hydrocarbon group which may contain an atom other than hydrogen and carbon.

The adhesive composition of the present invention is suited for use in a printed circuit board, especially for use in a flexible printed circuit board.

The printed circuits obtained using the adhesive composition of the present invention also exhibit excellent properties.

SPECIFIC EMBODIMENT FOR CARRYING OUT THE INVENTION

Hereinafter the present invention will be described in more detail. The adhesive composition according to the present invention is a resin composition comprising (1) a phosphoric acid ester, (2) a phenolic hydroxyl-containing aromatic compound having a softening point of 60 to 200°C, (3) an epoxy resin and (4) a carboxyl-containing nitrile-butadine rubber.

The phosphoric acid ester (1) is well compatible with a matrix resin and includes compounds represented by the following general formula (I):

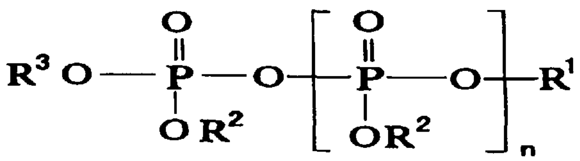

(I)

wherein n is an integer of not smaller than 0, preferably an integer of 0 to 2; each of $R^1$, $R^2$ and $R^3$ independently represents hydrogen or an alkyl group or an aromatic hydrocarbon group which may contain an atom(s) other than hydrogen and carbon.

Examples of the alkyl group shown by $R^1$, $R^2$ and $R^3$ include methyl, ethyl, n-butyl, etc. and examples of the aromatic hydrocarbon group include phenyl, p-nitrophenyl etc.

Examples of such phosphoric acid esters are trimethyl phosphate, triethyl phosphate, tributyl phosphate, tetraphenyl pyrophosphate, tetraethyl pyrophosphate and the like.

$R^1$, $R^2$ and $R^3$ may be an aromatic hydrocarbon group containing an atom other than hydrogen and carbon. Examples of such groups include an aromatic hydrocarbon group containing an oxygen and/or phosphor atom(s). Specifically preferred examples are those shown by the following formula (II):

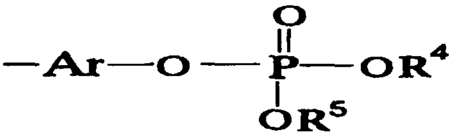

(II)

wherein each of $R^4$ and $R^5$ independently represents an alkyl group or an aromatic hydrocarbon group.

Examples of the alkyl group include an alkyl group having 1 to 8 carbon atoms such as methyl, ethyl, n-butyl, etc. Examples of the aromatic hydrocarbon group include a phenyl group which may optionally be substituted. Among them, the phenyl group which may optionally be substituted is particularly preferred. In the formula (II) described above, when $R^4$ and $R^5$ are both phenyl which may be substituted, the group is represented by the following formula (II-1):

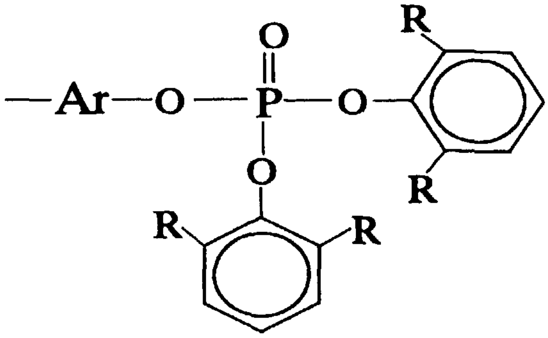

(II-1)

wherein R independently represents hydrogen, an alkyl group having 1 to 10 carbon atoms or an aromatic hydrocarbon group, and Ar represents an aromatic hydrocarbon group.

In the phosphoric acid ester of general formula (I) wherein n is 0, $R^1$ is an aromatic hydrocarbon group of formula (II-1) containing oxygen and phosphor and, $R^2$ and $R^3$ each is a phenyl group which may be substituted, the phosphoric add ester is an aromatic condensed phosphoric acid ester shown by the following formula (III):

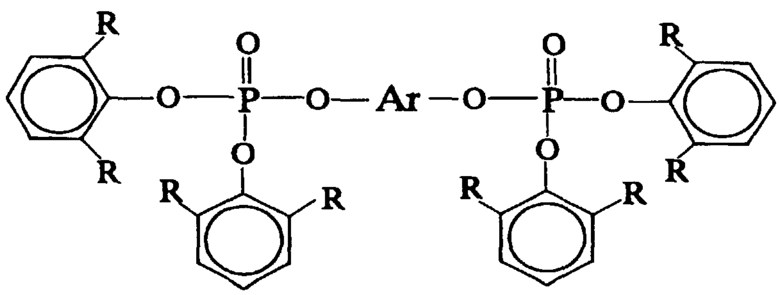

(III)

wherein R independently represents hydrogen, an alkyl group or an aromatic hydrocarbon group having 1 to 10 carbon atoms, and Ar represents an aromatic hydrocarbon group.

Examples of the alkyl group include an alkyl group having 1 to 8 carbon atoms such as methyl, ethyl, isopropyl, etc. Examples of the aromatic hydrocarbon group include an aromatic hydrocarbon group having 6 to 20 carbon atoms such as phenyl, naphthyl, etc.

Among the phosphoric acid esters of the present invention, the aromatic condensed phosphoric acid esters are preferred in view of non-volatility, phosphor content and resistance to hydrolysis. More preferred are compounds shown by the general formula (III) above.

Examples of the aromatic condensed phosphoric acid esters shown by the general formula (III) above are resorcinol bis(diphenyl phosphate) and compounds represented by formulae (IV) through (VIII), etc.

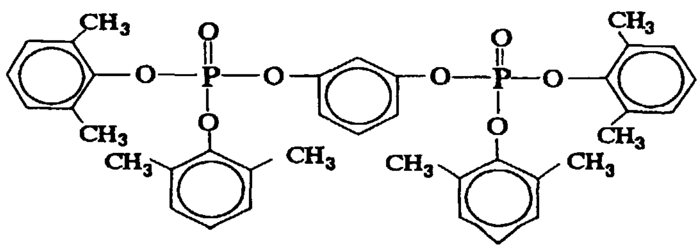

(IV)

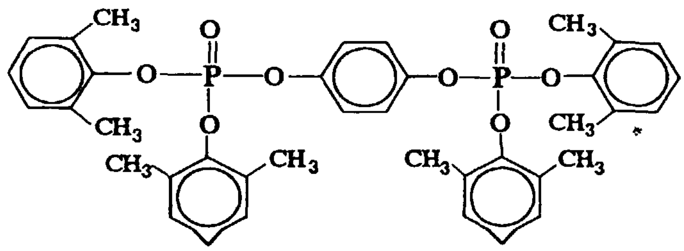

(V)

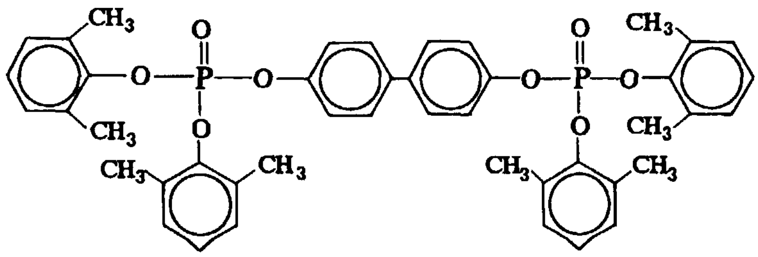

(VI)

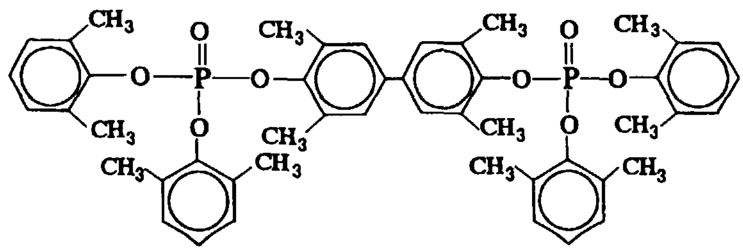

(VII)

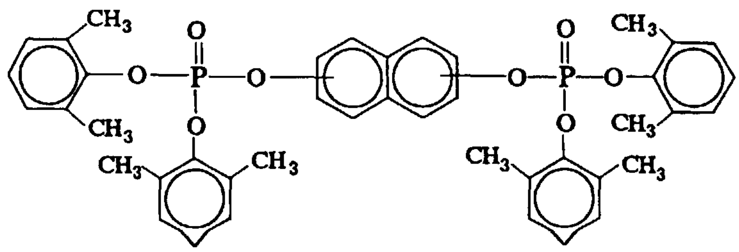

(VIII)

According to the present invention the adhesive composition contains the phosphoric acid ester (1) in an amount of 1 to 8 wt%, preferably 3 to 6 wt% when calculated as phosphor content, based on the solid content (excluding inorganic components such as an inorganic filler). Good flame retardancy, adhesion strength, soldering heat resistance and tack-free properties can be obtained when the phosphoric acid ester is contained in the range given above.

The phenolic hydroxyl-containing aromatic compounds (2) in accordance with the invention can be any compounds so long as they have a softening point of 60 to 200°C and contain a phenolic skeleton. Examples of such compounds include phenol resin, phenol-aralkyl resin, p-hydroxystyrene resin, methylidene trisphenol, etc. These

compounds may be employed alone or in admixture of two or more.

In the phenolic hydroxyl-containing aromatic compound, a novolak type phenolic resin is preferred in view of its costs, diverse derivatives and flexibility. More preferred novolak type phenolic resins are phenolic type resins or alkyl-modified phenolic type resins represented by the general formula (IX) below, and the like. These resins can be used solely or in admixture of two or more.

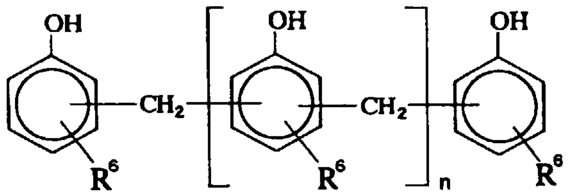

(IX)

In the formula (IX), n is an integer of not smaller than 0, preferably an integer of 0 to 5, more preferably an integer of 0 to 3. $R^6$ represents hydrogen or an alkyl group having 1 to 6 carbon atoms. Examples of the alkyl group having 1 to 6 carbon atoms include methyl, butyl, isopentyl, etc.

The softening point of the phosphoric acid ester (2) of the present invention is preferably in the range of 60 to 200°C, more preferably 75 to 200°C, in terms of blocking properties and solubility in solvent.

The epoxy resin (3) used in the present invention contains at least two epoxy groups per molecule. Examples of such epoxy resins include glycidyl ether type epoxy resins of polyphenolic compounds such as 2,2-bis(4'-oxyphenyl)propane, 2,2-bis(4'-hydroxyphenyl)butane, 1,1-bis(4'-hydroxyphenyl)ethane, bis(4-hydroxyphenyl)methane, 1,1,2,2-tetrakis(4'-hydroxyphenyl)ethane, 4-hydroxydiphenyl ether, p-(4-hydroxyphenyl)phenol, etc.; glycidyl ether type epoxy resins of these polyphenolic compounds wherein the aromatic ring is hydrogenated; glycidyl ether type epoxy resins of polyhydric phenols such as catechol, resorcine, hydroquinone, etc.; novolak type epoxy resins such as p-t-butylphenol novolak, o-cresol, phenol novolak, etc.; alicylic epoxy resins such as vinylcyclohexene dioxide, limonene dioxide, dicyclopentadiene dioxide,etc.; polyglycidyl ester type epoxy resins of ester condensation products from polycarboxylic acids such as phthalic acid, cyclohexane-1,2-dicarboxylic acid, etc.; polyglycidyl amine type epoxy resins such as triglycidyl isocyanurate, tetraglycidyl m-xylylenediamine, etc.

Examples of the carboxyl-containing nitrile-butadine rubber (4) used in the present invention include acrylonitrile-butadiene copolymer rubbers obtained by copolymerization of acrylonitrile with butadiene in a molar ratio of 3/97 to 60/40, preferably 5/95 to 45/55 in terms of heat resistance and flexibility, in which a terminal group is carboxylated, and terpolymer rubbers obtained by terpolymerization of acrylonitrile, butadiene and a carboxyl-containing polymeric monomer such as acrylic acid, methacrylic acid, etc.

The carboxyl content in the copolymer rubber is preferably in a range from 0.5 to 13 wt%, more preferably 1 to 8 wt% in view of adhesive and thermal resistance properties. The carboxyl-containing nitrile rubbers may also be used in the form of a solution or dispersion in an organic solvent, if conditions are permitted. As organic solvents available, methyl ethyl ketone, methyl isobutyl ketone, ethanol, isopropanol, methyl cellosolve and the like are advantageously used in view of their costs and drying properties in a B-staged state.

The components (2), (3) and (4) described above are used in the blending ratio of $0 <$ the component (2)/(the component (3) + the component (4)) $< 1$ , preferably $0.05 <$ the component (2)/(the component (3) + the component (4)) $< 0.7$ .

The components (3) and (4) are contained preferably in a weight ratio of the component (3)/the component (4) = 95/5 to 50/5 , more preferably 85/15 to 60/40. When the proportion of the component (3) is too low, heat resistance tends to decrease. Where the proportion of the component (3) is too high, adhesion strength and flexibility tend to be lowered.

In order to blend the components (1) through (4), any method can be appropriately chosen depending upon purpose. In general, the components (1) to (4) are dissolved all together and the resulting solution is provided for use. These components may also be separately dissolved to form two or more solutions and the solutions may be mixed immediately before use.

For preventing the oxidation or degradation of epoxy resins, stabilizers may also be incorporated in the adhesive composition. Non-staining stabilizers that do not cause color change are preferred. Preferred examples of such stabilizers include hindered phenolic stabilizers such as tetrakis[methylene-3-(3',5'-di-tert-butyl-4'-hydroxyphenyl)propionate]methane, 4,4'-methylene-bis(2,6-di-tert-butyl)phenol, 1,3,5-trimethyl-2,4,6-tris(3,5-di-tert-butyl-4-hydroxybenzyl)benzene, etc.; thiobisphenolic stabilizers such as 4,4'-thiobis(6-tert-butyl-3-methyl)phenol, 2,2'-thiobis(6-tert-butyl-4-methyl)phenol, etc.; aliphatic thioester stabilizers such as dilauryl thiodipropionate, etc. The amount

of these stabilizers may be appropriately chosen depending upon purposes for use but is generally set within 5 wt%, preferably within 3%, based on the solid content.

In applying the adhesive composition of the present invention, a curing agent is used. The phenolic hydroxyl-containing aromatic compound (2) contained as one of the essential components may be utilized also as a curing agent. Compounds conventionally known to be curing agents, e.g., aliphatic polyamines, aromatic polyamines, imidazoles, polyamides, acid anhydrides, phenols, polymercaptans, etc., are also available for the adhesive composition of the invention.

Where compounds other than the phenolic hydroxyl-containing aromatic compound (2) are used as the curing agent, it is preferred to mix such compounds with the components (1) to (4) previously and provide the mixture for use.

In general, the composition of the present invention is dissolved in a solvent and the resulting solution is applied to an adherend as an adhesive. Examples of solvents available include methyl ethyl ketone, methyl isobutyl ketone, dioxane, ethanol, methyl cellosolve, ethyl cellosolve, propylene glycol monoethyl ether, N-methylpyrrolidone, N,N-dimethylformamide, toluene, xylene, etc. These solvents may be used alone or in admixture in any volume, depending upon purpose.

Of these solvents, methyl ethyl ketone, propylene glycol monomethyl ether, toluene, xylene and N,N-dimethylformamide are preferred, taking into account costs and solubility.

The adhesive composition described above is coated onto an adherent such as a polyimide film, a polyester film, etc., and then B-staged. The coated adherent is pressed to bond to a metal foil such as a copper foil, an aluminum foil, etc. using a roller press or a batch press. Thus, a printed circuit board having excellent properties can be obtained. The press-bonding is preferably performed at a temperature of 50 to 350°C under a pressure of 0.1 to 30 MPa, more preferably at a temperature of 80 to 300°C under a pressure of 0.5 to 20 MPa, whereby adhesion strength and soldering heat resistance can be more improved. Further improved soldering heat resistance can be obtained by after-cure at 80 to 350°C, preferably at 100 to 300°C.

The board having the adhesive layer thus formed are effective for use in a printed circuit board, particularly for use in a flexible printed circuit board.

## EXAMPLES

Hereinafter the invention will be described in more detail with reference to Examples and Comparative Examples but the present invention is in no way limited to or by those examples.

### EXAMPLE 1

(1) Preparation of an adhesive:

In a 500 ml separable glass flask, 27 g of carboxyl-containing nitrile-butadine rubber (trade name NIPOL 1072B, manufactured by Nippon Zeon Co., Ltd.), 50 g of epoxy resin (trade name R301, manufactured by Mitsui Chemicals, Inc.), 50 g of aromatic condensed phosphoric add ester (trade name, PX-200, manufactured by Daihachi Chemical Ind. Corp.) as the phosphoric acid ester, 10 g of novolak phenol resin (trade name, HF-3, softening point: 94-98°C, Meiwa Chemical Co., Ltd.) as the phenolic hydroxyl-containing aromatic compound and 270 g of methyl ethyl ketone were charged all together. The mixture was vigorously stirred at room temperature for an hour. After completion of the stirring, the mixture was filtered through a 325 mesh metal filter under normal pressure to prepare the adhesive.

(2) Preparation of a curing agent:

In a 100 ml glass flask were charged all together 7.0 g of 3,3'-diaminodiphenylsulfone, 1.0 g of 1,4-diazabicyclo[5.4.0]7-undecene (manufactured by SAN-APRO Co., Ltd.) and 42.0 g of Hi Solve MP (trade name, made by Toho Chemical Industry Co., Ltd.) as propyleneglycol monomethyl ether. The mixture was stirred vigorously at room temperature for 30 minutes. After completion of the stirring, the mixture was filtered through a 325 mesh metal filter under normal pressure to prepare the curing agent.

(3) Performance evaluation:

The adhesive prepared above was mixed with the curing agent described above in a weight ratio of 8/1. After thoroughly shaking for a minute, the mixture was coated onto Kapton H (25 μm in thickness) using an applicator (clearance: 200 μm). The resulting film was dried in an oven at 130°C for 4 minutes to form an adhesive layer in a B-stage state. The adhesive layer in the B-stage state was laminated on a mat surface to be bonded of a rolled copper foil (thick-

ness: 35 μm), and then pressed under 1 MPa at 170°C for 120 minutes. The laminate sample thus prepared was evaluated by the following methods. The results of the evaluation are shown in Tables 1 and 2.

(1) Adhesion strength:

The adhesion strength (copper stretching) of the laminate sample was measured for a peel strength in a direction of 90° and 180° in accordance with JIS C-6481.

(2) Soldering heat resistance:

In accordance with JIS C-6481, the laminate sample was left under predetermined conditions (normal state: 23°C, 60% RH, moisturized: 40°C, 80% RH) for 24 hours; the sample was immersed in a solder bath heated at a predetermined temperature for 10 seconds and observed to check the presence of swelling at the polyimide surface.

(3) Flame retardancy:

The flame retardancy of the laminate sample was determined in accordance with the test method designated UL Standard 94. The results are shown in the following four levels.

V-0: In the combustion test with N=5 (5 repetitions) in which the laminate sample was placed in a vertical direction, the rating V-0 indicates that:

a flaming combustion time is within 5 seconds in average, within 10 seconds at longest,
glow disappearance within 30 seconds; and,
no sample drips flaming particles that ignite the dry cotton beneath the sample.

V-1: In the same combustion test as given above, the rating V-1 indicates that:

a flaming combustion time is within 25 seconds in average, within 30 seconds at longest,
glow disappearance within 60 seconds; and,
no sample drips flaming particles that ignite the dry cotton beneath the sample.

V-2: In the same combustion test as given above, the rating V-2 indicates that:

the flaming combustion time and glow disappearance are the same as in V-1; but,
the sample drips flaming particles which ignite the dry
cotton beneath the sample.

HB: In the combustion test with N=3 (3 repetitions) in which the laminate sample was placed horizontally, the flaming combustion rate is not more than 2.5 inch/min.

(4) Tackiness:

The adhesive surface is lightly poked with the finger to see if the surface is tacky. The results are shown by the following symbols.

○ : The surface does not stick to the finger.
X : The surface sticks to the finger.

EXAMPLE 2

Sample pieces were prepared in the same way as EXAMPLE 1 except that 50 g of triphenyl phosphate (TPP, manufactured by Daihachi Chemical Ind. Corp.) was used as the phosphoric acid ester in place of PX-200 in EXAMPLE 1, and the amounts of HF-3 and NIPOL 1072B were changed to 45 g and 50 g, respectively. Each of the sample pieces thus prepared was evaluated on its performance attributes in accordance with the same methods as in EXAMPLE 1. The results of evaluation are shown in Table 1.

EXAMPLE 3

Sample pieces were prepared in the same way as EXAMPLE 1 except that 50 g of KAYAHARD NHN (trade name, manufactured by Nippon Kayaku Co., Ltd., softening point: 139-147°C) was used as the phenolic hydroxyl-containing aromatic compound in place of HF-3 used in EXAMPLE 1, and the amounts of PX-200 and NIPOL 1072B were changed to 30 g and 45 g, respectively. Each of the sample pieces thus prepared was evaluated on its performance attributes in accordance with the same test methods as in EXAMPLE 1. The results of evaluation are shown in Table 1.

EXAMPLE 4

Sample pieces were prepared in the same way as EXAMPLE 1 except that in addition to 50 g of PX-200 used in EXAMPLE 1, 30 g of TPP was further used as the phosphoric add ester, 5 g of MARUKA LINKER M (Maruzen Petrochemical Co., Ltd., softening point, ca. 120°C) was substituted for HF-3 and the amount of NIPOL 1072B was changed to 20 g. Each of the sample pieces was evaluated on its performance attributes in accordance with the methods used in EXAMPLE 1. The results of evaluation are shown in Table 1.

EXAMPLE 5

Sample pieces were prepared in the same way as EXAMPLE 1 except that 50 g of trimethyl phosphate (TMP, manufactured by Daihachi Chemical Ind. Corp.) was used as the phosphoric acid ester in place of PX-200 in EXAMPLE 1, 50 g of MILEX (manufactured by Mitsui Chemicals, Inc., softening point: 85°C) was substituted for HF-3 and the amount of NIPOL 1072B was changed to 30 g. Each of The sample pieces was evaluated on its performance attributes by the same methods as in EXAMPLE 1. The performance attributes are shown in Table 1.

Table 1

| | | Example1 | Example2 | Example3 | Example4 | Example5 |
|---|---|---|---|---|---|---|
| Adhesive composition | (1)Phosphoric acid ester | | | | | |
| | PX-200 | 50 | | 30 | 50 | |
| | TPP | | 50 | | 30 | |
| | TMP | | | | | 50 |
| | (2)Phenolic hydroxyl-containing aromatic compound | | | | | |
| | HF-3 | 10 | 45 | | | |
| | KAYAHARD NHN | | | 50 | | |
| | MARUKA LINKER | | | | 5 | |
| | Milex | | | | | 50 |
| | (3)Epoxy resin 301 | 50 | 50 | 50 | 50 | 50 |
| | (4)Carboxyl-containing nitrile-butadiene rubber NIPOL 1072B | 27 | 50 | 45 | 20 | 30 |
| | Component(2) / Component(3)+(4) | 0.13 | 0.45 | 0.53 | 0.07 | 0.63 |
| | Component(3) /Component(4) | 65/35 | 50/50 | 53/47 | 71/29 | 63/37 |
| | Phosphor content based on solid content(%) | 3.3 | 2.4 | 1.5 | 4.7 | 6.1 |
| Performance evaluation | (1)Adhesion strength (N/cm) | | | | | |
| | 90℃ Peel strength | 12.5 | 15.3 | 12.8 | 12.0 | 12.3 |
| | 180℃ Peel strength | 13.0 | 17.5 | 14.0 | 10.8 | 13.0 |
| | (2)Soldering heat resistance (℃) | | | | | |
| | Normal state | 320 | 290 | 300 | 340 | 330 |
| | Moistured | 300 | 270 | 270 | 310 | 300 |
| | (3)Tackiness | ○ | ○ | ○ | ○ | ○ |
| | (4)Flame retardancy | V-0 | V-0 | V-0 | V-0 | V-0 |

COMPARATIVE EXAMPLES 1 through 5

The component ratio of the adhesive was changed as given in Table 2. Each of the sample pieces was evaluated as in EXAMPLE 1. The results are shown in Table 2.

Table 2

| | | Comp. Example1 | Comp. Example2 | Comp. Example3 | Comp. Example4 | Comp. Example5 |
|---|---|---|---|---|---|---|
| Adhesive composition | (1)Phosphoric acid ester<br>PX-200<br>TPP<br>TMP | | <br><br><br>20 | 50 | 50 | 50 |
| | (2)Phenolic hydroxyl-containing aromatic compound<br>HF-3<br>KAYAHARD NHN<br>MARUKA LINKER<br>Milex | 10 | 10 | 75 | | 75 |
| | (3)Epoxy resin<br>301 | 50 | 50 | | 50 | 50 |
| | (4)Carboxyl-containing nitrile-butadiene rubber<br>NIPOL 1072B | 27 | | 20 | 27 | 20 |
| | Component(2) / Component(3)+(4) | 0.1 | 0.2 | 3.8 | 0.0 | 1.1 |
| | Component(3) /Component(4) | 65/35 | – | – | 65/35 | 71/29 |
| | Phospher content based on solid content(%) | 0.0 | 5.5 | 3.1 | 3.5 | 2.3 |
| Performance evaluation | (1)Adhesion strength (N/cm)<br>90°C Peel strength<br>180°C Peel strength | <br>14.5<br>13.5 | <br>–<br>– | <br>3.0<br>3.3 | <br>12.0<br>12.0 | <br>9.0<br>9.2 |
| | (2)Soldering heat resistance (°C)<br>Normal state<br>Moistured | <br>340<br>320 | <br>–<br>– | <br><250<br><230 | <br>330<br>300 | <br>300<br>280 |
| | (3)Tackiness | ○ | – | × | × | ○ |
| | (4)Flame retardancy | HB | – | HB | HB | V−1 |

POSSIBILITY OF INDUSTRIAL USE

The adhesive composition of the present invention provides excellent adhesive strength, soldering heat resistance, flame retardancy, heat aging resistance and tack-free properties and hence, is useful as a flame retardant adhesive, especially as an adhesive for use in a flexible printed circuit board.

## Claims

1. An adhesive composition comprising (1) a phosphoric acid ester represented by general formula (I) below, (2) a phenolic hydroxyl-containing aromatic compound having a softening point of 60 to 200°C, (3) an epoxy resin and (4) a carboxyl-containing nitrile-butadine rubber, a blending ratio of the components (2), (3) and (4) being 0 < the component (2)/(the component (3) + the component (4)) < 1 :

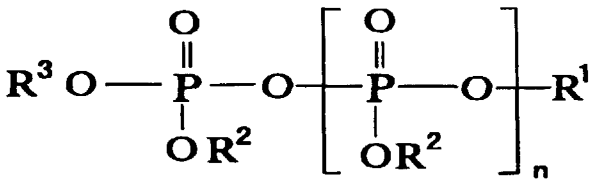

(I)

wherein n is an integer of not smaller than 0; each of $R^1$, $R^2$ and $R^3$ independently represents hydrogen or, an alkyl group or an aromatic hydrocarbon group which may contain an atom(s) other than hydrogen and carbon.

2. The adhesive composition according to claim 1, wherein the phosphoric add ester (1) is an aromatic condensed phosphoric acid ester.

3. The adhesive composition according to claim 2, wherein the aromatic condensed phosphoric acid ester is a compound represented by general formula (III) below:

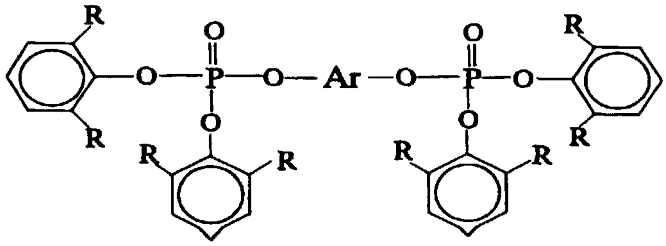

(III)

wherein R independently represents hydrogen, an alkyl group or an aromatic hydrocarbon group having 1 to 10 carbon atoms, and Ar represents an aromatic hydrocarbon group.

4. The adhesive composition according to claim 1, wherein the phenolic hydroxyl-containing aromatic compound having a softening point of 60 to 200°C is a novolak type phenolic resin represented by general formula (IX) below:

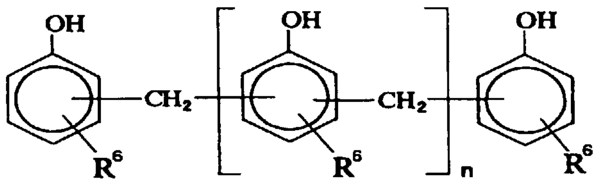

(IX)

wherein n is an integer of not smaller than 0 and $R^6$ represents hydrogen or an alkyl group having 1 to 6 carbon atoms.

5. The adhesive composition according to any one of claims 1 through 3, wherein the phosphoric add ester (1) is contained in an amount of 1 to 8 wt%, when calculated as phosphor content, based on the solid content (excluding inorganic components).

6. Use of the adhesive composition according to any one of claims 1 through 5 in a printed circuit board.

7. A printed circuit board prepared using the adhesive composition according to any one of claims 1 through 5.

## INTERNATIONAL SEARCH REPORT

International application No.
PCT/JP99/05896

A. CLASSIFICATION OF SUBJECT MATTER
Int. Cl⁷ C09J163/00, C09J109/02, C09J161/10, H05K1/03

According to International Patent Classification (IPC) or to both national classification and IPC

B. FIELDS SEARCHED

Minimum documentation searched (classification system followed by classification symbols)
Int. Cl⁷ C09J1/00-C09J201/10, C08L1/00-C08L101/14, H05K1/00-3/46

Documentation searched other than minimum documentation to the extent that such documents are included in the fields searched

Electronic data base consulted during the international search (name of data base and, where practicable, search terms used)
CA(STN), WPI/L (QUESTEL), REGISTRY(STL)

C. DOCUMENTS CONSIDERED TO BE RELEVANT

| Category* | Citation of document, with indication, where appropriate, of the relevant passages | Relevant to claim No. |
|---|---|---|
| Y | JP, 2-187485, A (Toshiba Chemical Co.), 23 July, 1990 (23.07.90), Claims: page 3, upper right column (Family: none) | 1-7 |
| Y | JP, 4-199694, A (shin-Etsu Chemical Co., Ltd.), 20 July, 1992 (20.07.90), Claims (Family: none) | 1-7 |
| Y | JP, 9-302313, A (Hitachi Chemicals Co., Ltd.), 25 November, 1997 (25.11.97), Claims; Par. Nos. [0009], [0011] (Family: none) | 1-7 |
| Y | JP, 10-182792, A (Hitachi Chemicals Co., Ltd.), 07 July, 1998 (07.07.98), Claims (Family: none) | 1-7 |
| Y | JP, 53-108180, A (Sumitomo Bakelite Co., Ltd.), 20 September, 1978 (20.09.78), Claims (Family: none) | 1-7 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 January, 2000 (13.01.00) | 25 January, 2000 (25.01.00) |
| Name and mailing address of the ISA/ Japanese Patent Office | Authorized officer |
| Facsimile No. | Telephone No. |

Form PCT/ISA/210 (second sheet) (July 1992)

INTERNATIONAL SEARCH REPORT

International application No. PCT/JP99/05896

C (Continuation). DOCUMENTS CONSIDERED TO BE RELEVANT

| Category* | Citation of document, with indication, where appropriate, of the relevant passages | Relevant to claim No. |
|---|---|---|
| PA | JP, 11-61073, A (Mitsui Chemicals, Ltd.), 05 March, 1999 (05.03.99), Claims (Family: none) | 1-7 |
| PA | JP, 11-181380, A (Mitsui Chemicals, Ltd.), 06 July, 1999 (06.07.99), Claims (Family: none) | 1-7 |

Form PCT/ISA/210 (continuation of second sheet) (July 1992)